# EUROPEAN PATENT APPLICATION

(11) **EP 1 571 702 A2**
(43) Date of publication of application: **07.09.2005**
(21) Application number: 05251308.2
(22) Date of filing: 04.03.2005
(51) Int. Cl.: H01L 21/28, H01L 29/792

(54) **Method of manufacturing memory device comprising gate having uniformly distributed silicon nano dots**

(30) Priority: 04.03.2004 KR 2004014594
(71) Applicant: SAMSUNG ELECTRONICS CO., LTD., Gyeonggi-do (KR)
(72) Inventor: Yoo, In-kyeong, Suwon-si Gyeonggi-do (KR); Jeong, Soo-hwan, Yongin-si Gyeonggo-do (KR); Ryu, Won-il, Gangnam-gu Seoul (KR)
(74) Representative: Greene, Simon Kenneth

(57) **Abstract**

Provided is a method of manufacturing a memory device which comprises a gate including uniformly distributed silicon nano dots. The method includes forming a gate on a substrate, the gate including an insulating film, sequentially stacked nano dot layers separated by a predetermined distance, and a conductive film pattern, forming a source region and a drain region contacting the gate in the substrate, and forming first and second metal layers on the source region and the drain region, respectively.

## Description

The present invention relates to a method of manufacturing a semiconductor device, and more particularly, to a method of manufacturing a memory device including a gate having uniformly distributed nano dots.

As the size of MOSFETs decreases, problems arise, making it difficult to further reduce the size of MOSFETs.

For example, as the size of MOSFETs decreases, problems such as drain induced barrier lowering (DIBL) and punchthrough due to the reduction of an effective channel length and the degradation of an oxide film and the increases in the leakage current by hot carriers generated by the field increase inside devices arise. These problems prevent reducing the size of the MOSFETs.

However, when the MOSFETs are scaled down to a nanometer level, fundamental physical limitations will be encountered.

That is, in a nano-scaled MOSFET, the number of electrons related to the operation of the device and the number of electrons related to the thermal fluctuation are almost equal. Therefore, stable operation at room temperature can not be achieved.

Accordingly, it is necessary to replace the MOSFET having the problems with other devices. A flash memory device is one of the other devices.

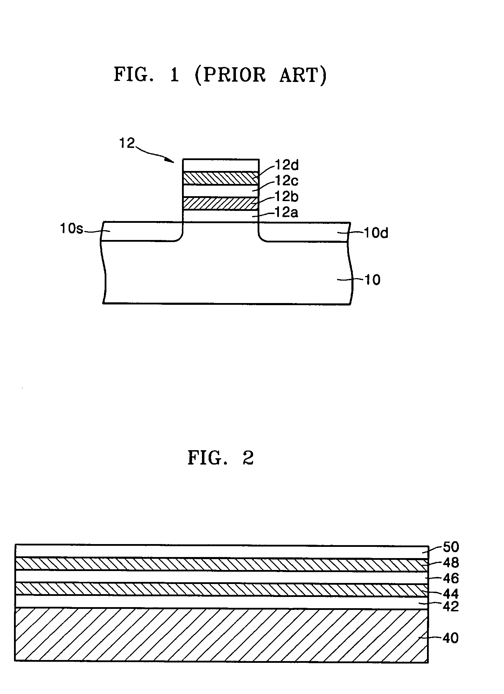

Referring to FIG.1, a conventional flash memory device comprises a substrate 10 used in a conventional MOSFET and a gate stack 12 formed on the substrate 10. A source region 10s and a drain region 10d separated by a predetermined distance are formed in the substrate 10. The gate stack 12 is located on the substrate 10 between the source region 10s and a drain region 10d. The gate stack 12 comprises a gate insulating film 12a, a floating gate 12b where electrons are trapped, an interlayer insulating layer 12c, and a control gate 12d stacked sequentially.

The flash memory device is a FET and also a nonvolatile memory device in which electrons trapped in the floating gate 12b remain after power is turned off. Therefore, it is possible to realize a nonvolatile memory device whose price is lower than that of a DRAM using a flash memory device.

In spite of this advantage, the flash memory device depicted in FIG. 1 has a low recording speed, has a high recording voltage and can only be recorded to about 10,000 times, and the gate insulating film of the flash memory device has to be formed sufficiently thick to increase a retention time. Therefore, the amount of that the flash memory device can be scaled down is limited.

Recently, flash memory devices using nano techniques have been introduced. Such a flash memory device includes a floating gate formed of nano dots.

However, in this case, since an etching process for forming the floating gate is performed after forming the nano dots, a boundary of the gate becomes uneven near the nano dots due to the etch selectivity of the nano dots with respect to the gate insulating film, and, in particular, a portion of nano dots can burst out from the gate.

According to an aspect of the present invention, there is provided a method of manufacturing a memory device, comprising forming a gate on a substrate, the gate including an insulating film and also a nano dot layer and a conductive film pattern which are sequentially stacked and separated by a predetermined distance from each other in the insulating film, forming a source region and a drain region each in the substrate and forming first and second metal layers on the source region and the drain region, respectively.

The present invention provides a method of manufacturing a memory device in which silicon nano dots are distributed in a gate and which aims to prevent nano dots from bursting out from the gate.

The step of forming the gate may comprise the method of claim 1, wherein forming the gate comprises forming a gate stack on the substrate, the gate stack including the insulating film and also a material film for forming the nano dot layer and the conductive film pattern which are sequentially stacked and separated by a predetermined distance in the insulating film and transforming the material film to the nano dot layer, which includes at least one nano dot.

Transforming the material films may include annealing the gate stack until the material films for forming the nano dot layer becomes the nano dot layer.

Forming the gate stack may comprise sequentially stacking a first insulating film, the material film for forming the nano dot layer, a second insulating film, a conductive film, and a third insulating film on the substrate, forming a stack by patterning the first insulating film, the material film for forming the nano dot layer, the second insulating film, the conductive film, and the third insulating film, and forming a spacer on a side surface of the stack.

Forming the source and drain regions may be performed prior to the transforming the material film for forming the nano dot layers into the nano dot layer.

The material film for forming the nano dot layer may be one of a SiO₂₋ₓ film and a Si₃N₄₋ₓ film (0<x<1).

The gate may be annealed at a temperature of 700-1100 °C for 30 seconds to1 hour.

According to another aspect of the present invention, there may be provided forming the gate comprising: forming a first insulating film on the substrate, forming a material film for forming nano dots on the first insulating film, forming a nano dot material film pattern that confines a region for forming the gate by patterning the material film for forming nano dots, transforming the nano dot material film pattern into the nano dot layer which includes at least one nano dot, forming a second insulating film covering the nano dot layer on the first insulating film, forming the conductive film pattern on a region of the second insulating film above the nano dot layer, forming a third insulating film covering the conductive film pattern on the second insulating film, and patterning the first through third insulating films so that the conductive film pattern and the nano dot layer are included in the resultant product.

The first through third insulating films may be formed of identical materials.

The material film for forming the nano dot may be formed with one of a SiO₂₋ₓ film and a Si₃N₄₋ₓ film (0<x<1).

The material film for forming the nano dots may be transformed into the nano dot layer by annealing.

The annealing may be performed at a temperature of 700-1100 °C for 30 seconds to 1 hour.

According to another aspect of the present invention, there may be provided the forming the gate comprising: forming a first insulating film on the substrate, injecting seeds for forming nano dots in the first insulating film, forming a first insulating film pattern that defines a region for forming a gate by patterning the first insulating film in which the seeds are injected, forming a nano dot layer that includes at least one nano dot in the first insulating film pattern, forming a second insulating film covering the first insulting film pattern including the nano dot layer on the substrate, forming a conductive film pattern on a portion of the second insulating film directly above the nano dot layer, forming a third insulating film covering the conductive film pattern on the second insulating film, and patterning the first through third insulating films so that the conductive film pattern and the nano dot layer are included in the resultant product.

The first through third insulating films may be formed with a silicon oxide film.

The seeds may be silicon seeds.

The patterning the first insulating film may be performed prior to the injecting the seeds for forming nano dots into the first insulating film.

The nano dot layer may be formed by annealling the first insulating film pattern.

The annealing may be performed at a temperature of 700-1100 °C for 30 seconds to 1 hour.

The use of the present invention can form uniformly distributed silicon nano dots in a gate of a memory device without protruding the nano dots to the outside of the gate.

The above and other features and advantages of the present invention will become more apparent by describing in detail exemplary embodiments thereof with reference to the attached drawings in which:
FIG. 1 is a cross-sectional view of a conventional flash memory device;
FIGS. 2 through 6 are cross-sectional views illustrating a method of manufacturing a memory device that includes a gate having uniformly distributed silicon nano dots according to a first embodiment of the present invention;
FIGS. 7 through 16 are cross-sectional views illustrating a method of manufacturing a memory device that includes a gate having uniformly distributed silicon nano dots according to a second embodiment of the present invention;
FIGS. 17 through 29 are cross-sectional views illustrating a method of manufacturing a memory device that includes a gate having uniformly distributed silicon nano dots according to a third embodiment of the present invention;
FIG. 30 is a SEM image of a cross-sectional view of the gate of a memory device formed according to an embodiment of the present invention; and
FIG. 31 is a SEM image of silicon nano dots included in the gate of a memory device formed according to an embodiment of the present invention.

The present invention will be described more fully with reference to the accompanying drawings in which preferred embodiments of the invention are shown by way of example. In the drawings, the thicknesses of layers and regions are exaggerated for clarity. Like reference numerals refer to like elements throughout the drawings.

### < First Embodiment>

A method of manufacturing a memory device according to a first embodiment of the present invention (hereinafter, first manufacturing method) will now be described with reference to FIGS. 2 through 6. Referring to FIG. 2, a first insulating film 42, a nano dots material film 44 for forming nano dots, a second insulating film 46, a conductive film 48, and a third insulating film 50 are sequentially formed on a substrate 40. The substrate 40 can be a semiconductor substrate, and the first insulating film 42, which is a tunnelling film, can be a silicon oxide film (SiO₂). The nano dots material film 44 can be a material film having a sufficient thickness for trapping electrons such as a silicon oxide (SiO₂₋ₓ) film or a nitride film (Si₃N₄₋ₓ), where 0<x<1. The second insulating film 46 can be a predetermined oxide film such as a silicon oxide film. Also, the conductive film 48 for forming a control gate can be a doped polysilicon film or a metal film. Next, a photosensitive film pattern (not shown) defining a gate forming area is formed on the third insulating film 50.

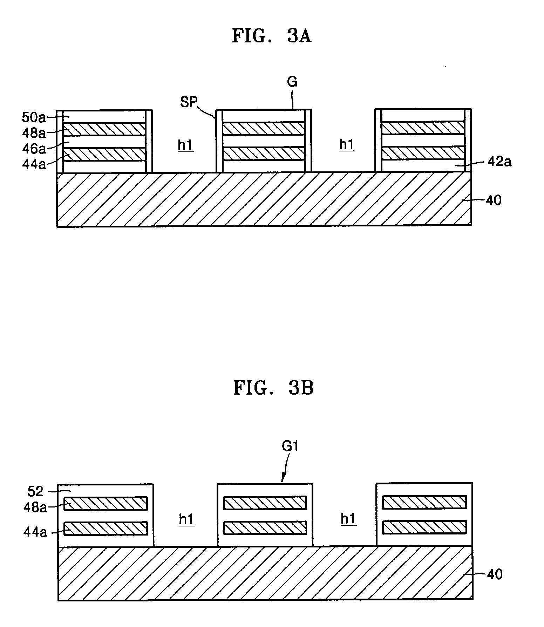

Then, the third insulating film 50, the conductive film 48, the second insulating film 46, the nano dots material film 44, and the first insulating film 42 are sequentially etched using the photosensitive film pattern as a mask. The etching is performed until the substrate 40 is exposed. When the etching is completed, the photosensitive film pattern is removed. As a result, a gate stack G is formed on a predetermined region of the substrate 40 as depicted in FIG. 3a, and holes h1 that expose the substrate 40 are formed between the gate stack G. The regions of the substrate 40 exposed through the holes h1 are regions where a source and a drain will be formed in a subsequent process. The gate stack G is composed of patterns of the sequentially stacked films 42, 44, 46, 48 and 50.

After forming the gate stack G, a thin silicon oxide film covering the gate stack G is formed on the substrate 40, and the silicon oxide film is anisotropically etched. Because of the characteristics of the anisotropic etching, except for portions formed on the side surfaces of the gate stack G, the thin silicon oxide film is removed. Therefore, a silicon oxide film pattern SP, spacer, is formed on only side surfaces of the gate stack G.

Referring to FIG. 3b, a first gate G1 in which the gate stack G and the spacers SP are combined can be formed. The spacers SP and the first through third insulating film patterns 42a, 46a, and 50a can be composed of different materials, or the same materials. In FIG. 3B, they are composed of the same material, therefore, they are indicated as a material film 52.

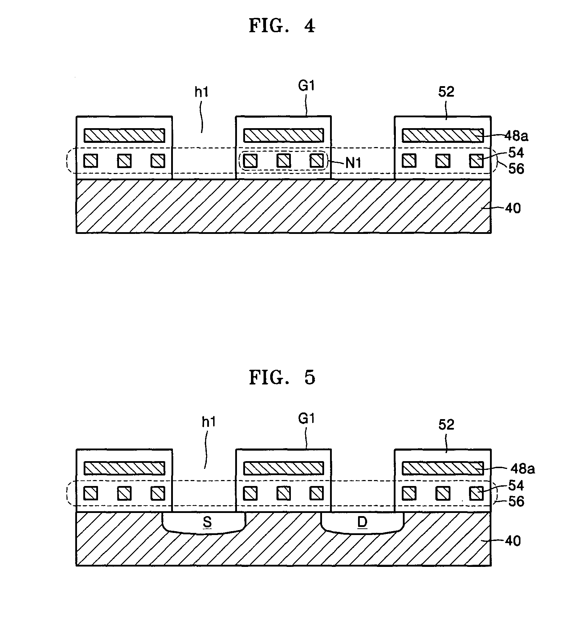

Referring to FIG. 4, after forming the first gate G1 on the substrate 40, the resultant product is annealed in an annealing apparatus for a predetermined time and at a predetermined temperature. While annealing, silicon Si is extracted from a nano dot material film pattern 44a, and nano-sized crystal dots are formed in the nano dot material film pattern 44a of the first gate G1. Thus, the nano dot material film pattern 44a becomes a nano dot layer 56 that includes nano-sized crystal nano dots 54 regularly distributed. The nano dot layer 56 includes a plurality of nano dot groups N1 separated by a predetermined distance, and each of the nano dot groups N1 includes a plurality of nano dots 54. The nano dot layer 56 is a floating gate, and electrons are trapped in each of the nano dots 54. Accordingly, the nano dot layer 56 can be used as a storage electrode.

After forming the nano dot layer 56 in the first gate G1, the resultant product is unloaded from the annealing apparatus.

Referring to FIG. 5, source and drain regions S and D are formed in predetermined regions of the substrate 40 exposed through the holes h1 by injecting a conductive dopant into the substrate 40.

In this manner, a transistor that includes the first gate G1, a source region S, and a drain region D is formed on the substrate 40. Since the first gate G1 includes the nano dot layer 56 that can be used as a storage electrode, the transistor can be used as a single electron memory device.

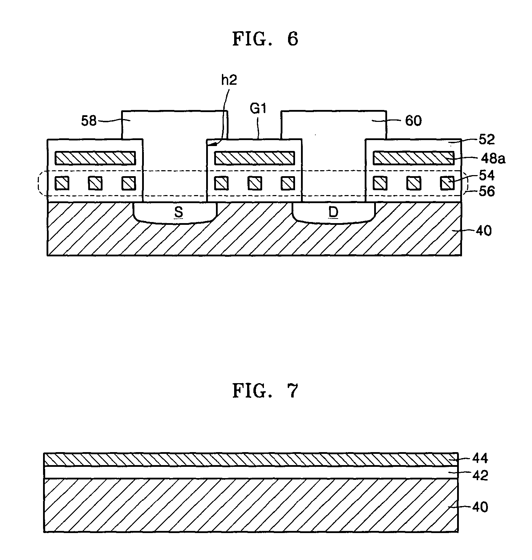

Referring to FIG. 6, a first metal layer 58 that contacts the source region S through the hole h1 and a second metal layer 60 that contacts the drain region D through the holes h1 are formed. The first and second metal layers 58 and 60 can be formed by forming a metal layer (not shown) that fills the holes h1 on the first gate G1, forming a photosensitive film pattern (not shown) that defines the first and second metal layer 58 and 60 on the metal layer, and then etching the metal layer using the photosensitive film pattern as an etch mask.

### <Second Embodiment>

A method of manufacturing (hereinafter, a second manufacturing method) a memory device according to a second embodiment of the present invention will now be described. In the present embodiment, a nano dot layer is formed prior to the formation of a control gate and a second gate, unlike in the first embodiment.

Descriptions of elements included in both the first and the second embodiments will not be repeated.

Referring to FIG. 7, a first insulating layer 42 and a nano dot material film 44 are sequentially formed on a substrate 40. The size of nano dots to be formed in a subsequent process may vary depending on the thickness of the nano dot material film 44. Therefore, the nano dot material film 44 can be formed to different thicknesses according to the desired size of the nano dots. For example, the nano dot material film 44 can be formed to an appropriate thickness so that the nano dots are 2-5 nm in diameter.

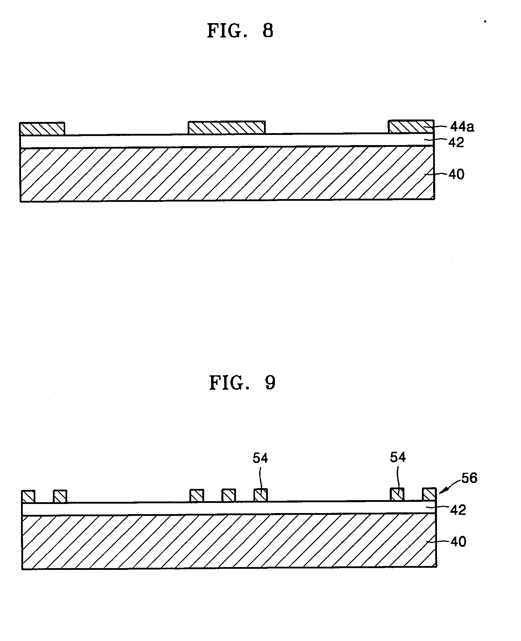

Referring to FIG. 8, a nano dot material film pattern 44a that exposes a predetermined region of the first insulating film 42 is formed on the first insulating film 42 by forming a photoresist pattern on the nano dot material film 44 and etching the nano dot material film 44 using the photoresist pattern as an etch mask. A source and drain will be formed in regions of the substrate 40 below the exposed region of the first insulating film 42 in a subsequent process. After forming the nano dot material film pattern 44a, the resultant product is annealed in a predetermined annealing apparatus at a predetermined temperature and pressure for a predetermined time. While annealing, silicon is extracted from the nano dot material film pattern 44a, the the nano dots are formed in the nano dots material film pattern 44a. As a result, the nano dot material film pattern 44a becomes a nano dot layer 56 having a plurality of uniformly distributed nano dots 54 as shown in FIG. 9.

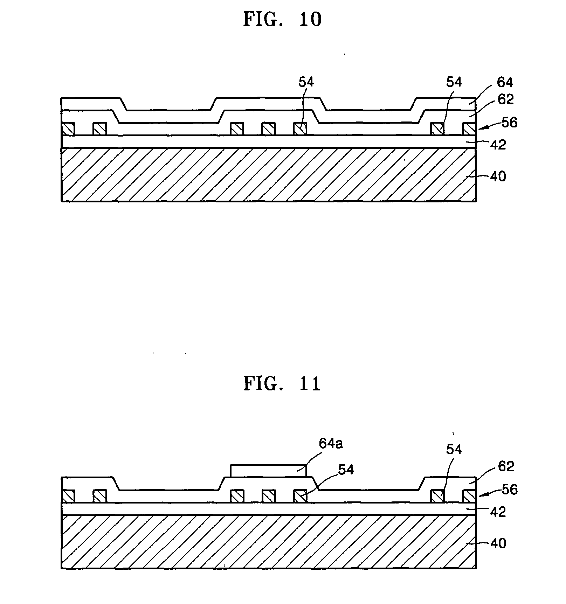

Referring to FIG. 10, a fourth insulating film 62 and a conductive film 64 covering the nano dot layer 54 are sequentially formed on the first insulating film 42. The fourth insulating film 62 can be a predetermined oxide layer such as a silicon oxide film. The fourth insulating film 62 can correspond to the second insulating film 46 of the first manufacturing method. The conductive film 64 can be a doped polysilicon film or a metal film. The conductive film 64 can correspond to the conductive film 48 of the first manufacturing method.

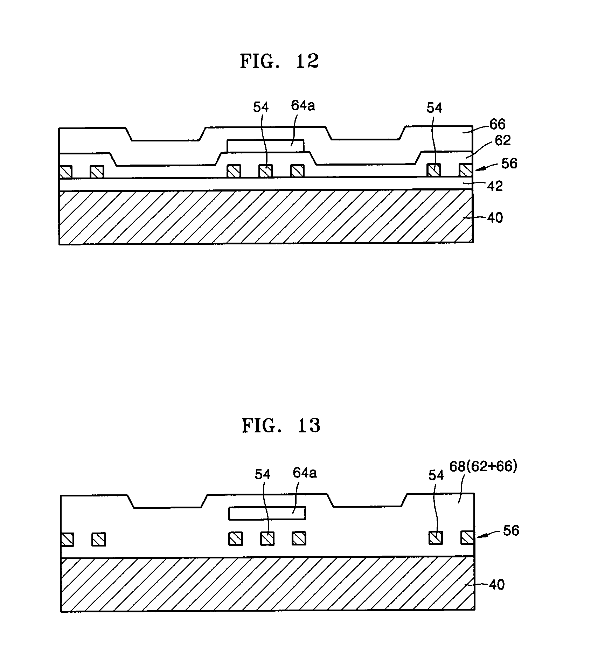

Referring to FIG. 11, after forming the conductive film 64, a conductive film pattern 64a can be formed on a predetermined region of the fourth insulating film 62 by forming an etch mask on the fourth insulating film 62 and etching the conductive film 64. The conductive film pattern 64a can be formed directly above some of the nano dot layer 56, as depicted in FIG. 11.

Referring to FIG. 12, a fifth insulating film 66 is formed on the conductive film pattern 64a and the fourth insulating film 62. The fifth insulating film 66 can be a predetermined oxide film such as a silicon oxide film. In this case, referring to FIG. 13, since the first insulating film 42, the fourth insulating film 62, and the fifth insulating film 66 are all composed of the same material, they can be indicated as a sixth insulating film 68.

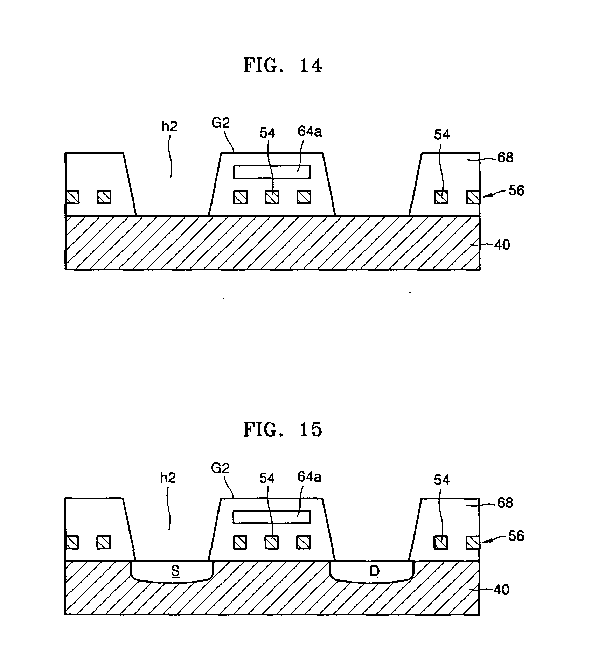

Referring to FIG. 14, holes h2 that expose the substrate 40 are formed in the sixth insulating film 68 between the conductive film patterns 64a, thereby forming a second gate G2 on the substrate 40 between the two holes h2. The second gate G2 includes the sixth insulating film 68 and the nano dot layer 56 and the conductive film pattern 64a attacked sequentially. The second gate G2 is identical to the first gate G1 formed in the first manufacturing method.

Referring to FIG. 15, a source region S and a drain region D are formed in predetermined regions of the substrate 40 by injecting a conductive dopant through the holes h2.

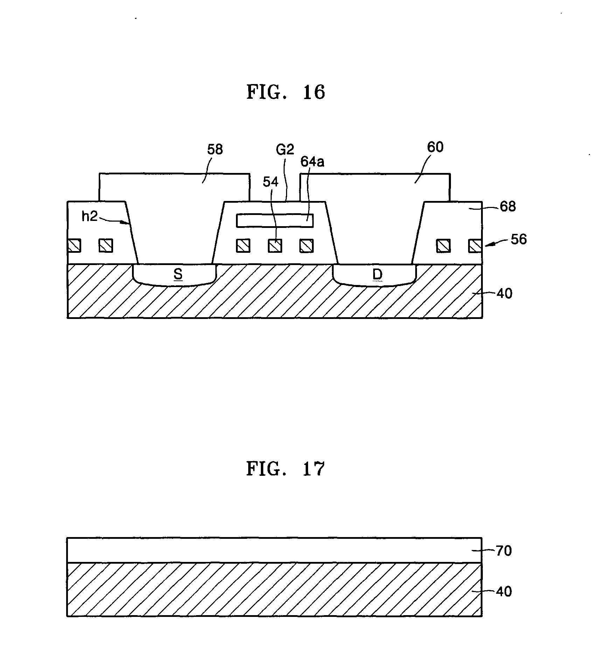

Referring to FIG. 16, a first metal layer 58 which contacts the source region S and a second metal layer 60 which contacts the drain region D are formed on the second gate G2. The first and second metal layers 58 and 60 are separated from each other.

### <Third Embodiment>

A method of manufacturing (hereinafter, a third manufacturing method) a memory device according to a third embodiment of the present invention will now be described. In the present embodiment, after ionic injecting silicon into a first insulating film 42 used as a tunnelling film and patterning the first insulating film 42, nano dots are formed in the patterned first insulating film 42.

Descriptions of elements included in the present embodiment and the above described embodiments will not be repeated.

Referring to FIG. 17, a seventh insulating film 70 is formed on the substrate 40. The seventh insulating film 70 can be a predetermined oxide film such as a silicon oxide film.

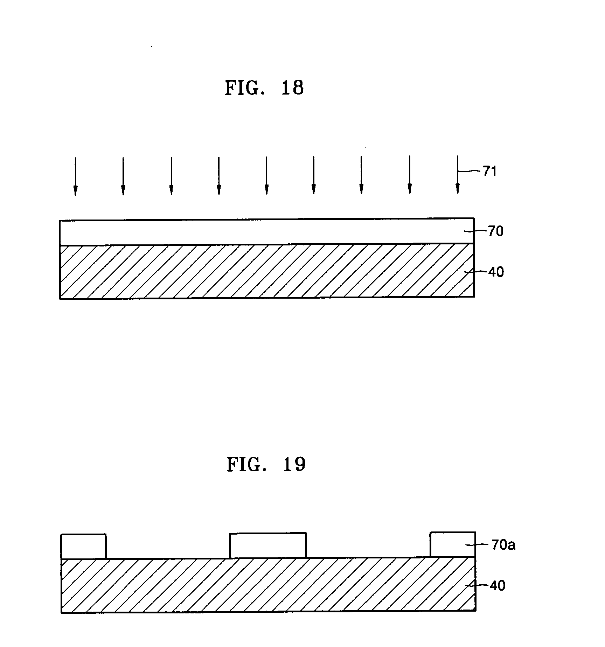

Referring to FIG. 18, seeds such as silicon Si for forming nano dots are doped into the seventh insulating film 70. The seeds can be implanted in the surface of the seventh insulating film 70. The thickness of the seventh insulating film 70 can be varied according to the desired size of nano dots. For example, the seventh insulating film 70 can be formed to an appropriate thickness such that the nano dots can have diameters of 2-5 nm.

Referring to FIG. 19, a seventh insulating film pattern 70a is formed on the substrate 40 by forming an etch mask on the doped seventh insulating film 70 and etching the doped seventh insulating film 70. When forming the seventh insulating film pattern 70a, predetermined regions of the substrate 40 are exposed by removing portions of the seventh insulating film 70. A source region S and a drain region D will be formed in the exposed regions in a subsequent process.

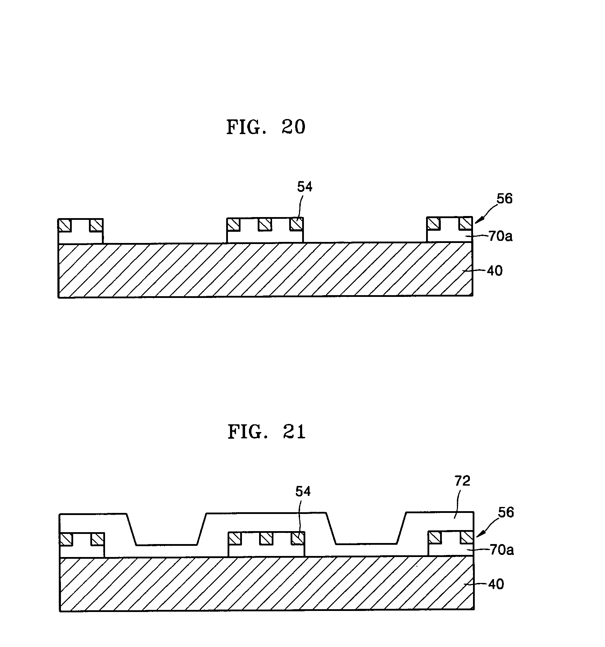

Referring to FIG. 20, after forming the seventh insulating film pattern70a, the seventh insulating film pattern 70a is annealed in an annealing apparatus at a predetermined pressure and temperature for a predetermined time. While annealing, the doped seeds, i.e., silicon seeds, are extracted and the formation of nano dots begins. When the annealing is completed, a nano dot layer 56 in which a plurality of nano dots 54 are regularly distributed is formed in an upper region of the seventh insulating film pattern 70a.

Referring to FIG. 21, an eighth insulating film 72 is formed on the seventh insulating film pattern 70a and the substrate 40. The eighth insulating film 72 can be a predetermined oxide film such as a silicon oxide film. The eighth insulating film 72 is identical to the second insulating film 46 of the first manufacturing method and the fifth insulating film 66 of the second manufacturing method.

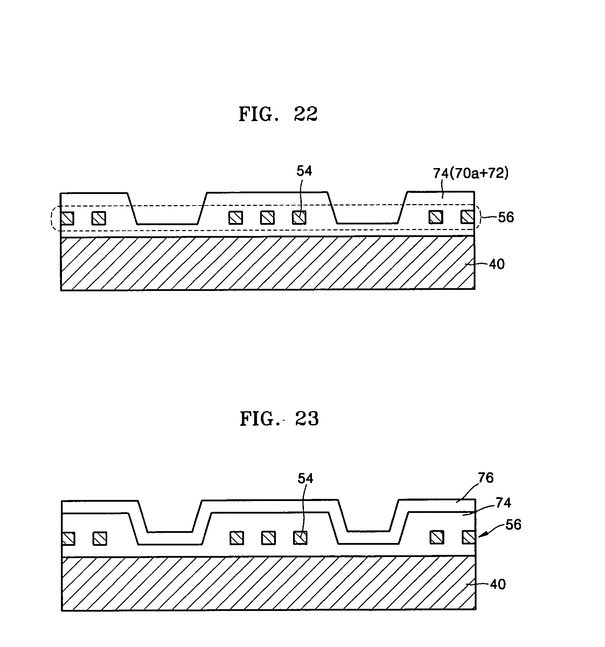

The seventh insulating film pattern 70a and the eighth insulating film 72 can be identical insulating films. Therefore, the seventh insulating film pattern 70a and the eighth insulating film 72 can be indicated as an insulating film 74, that is, a ninth insulating film as depicted in FIG. 22.

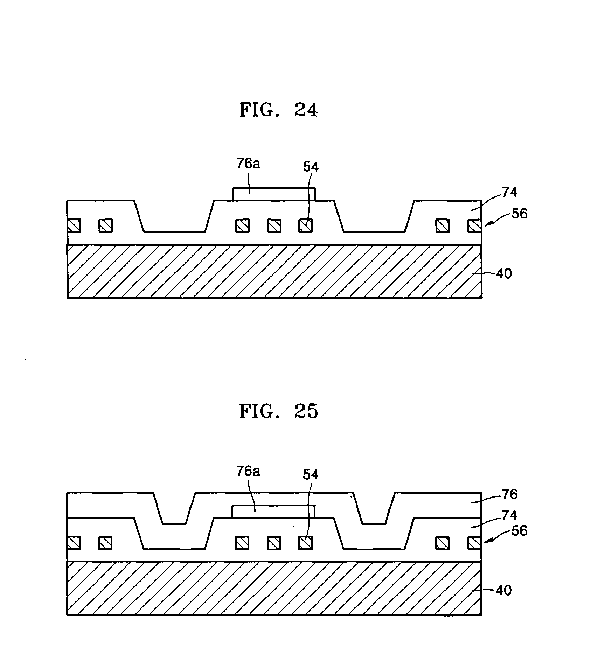

Referring to FIG. 23, a conductive film 76 to be used as a control gate is formed on the ninth insulating film 74. The conductive film 76 can be a doped polysilicon film or a metal film. Referring to FIG. 24, a conductive film pattern 76a is formed above the nano dot layer 56 on the ninth insulating film 74 by patterning the conductive film 76.

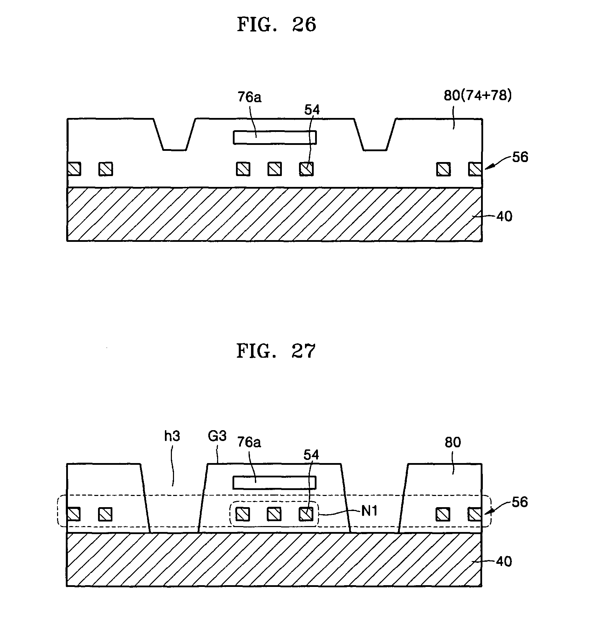

Referring to FIG. 25, a tenth insulating film 78 with a predetermined thickness is formed on the ninth insulating film 74 and the conductive film pattern 76a. The tenth insulating film 78 can be a predetermined oxide film such as a silicon oxide (SiO₂) film. The ninth insulating film 74 and the tenth insulating film 78 can be identical insulating films. Therefore, they are indicated as an eleventh insulating film 80, as depicted in FIG. 26.

Referring to FIG. 27, holes h3 that expose the substrate 40 are formed by patterning the eleventh insulating film 80, thereby forming a third gate G3. The configuration of the third gate G3 is identical to those of the first gate G1 and the second gate G2. The third gates G3 are formed between the holes h3. The holes h3 expose regions for forming a source region S and a drain region D in the substrate 40.

As described above, the nano dot layer 56 is composed of a plurality of nano dot groups N1 disposed regularly, and each of the nano dot groups N1 includes a plurality of nano dots 54. The third gate G3 includes a nano group like the first and second gates G1 and G2. Since the nano dot groups N1 are formed within the eleventh insulating film 80, the nano dots 54 that constitute the nano dot groups N1 are not exposed externally, and outlines of the nano dots 54 do not appear on a side surface of the third gate G3.

That is, since the nano dots 54 do not exist where the holes h3 are formed, problems such as a protrusion of nano dots 54 through the side surface of the third gate G3 or an uneven surface around the third gate G3 due to the etch selectivity of the nano dots 54 with respwct to the eleventh insulating film 80 can be prevented.

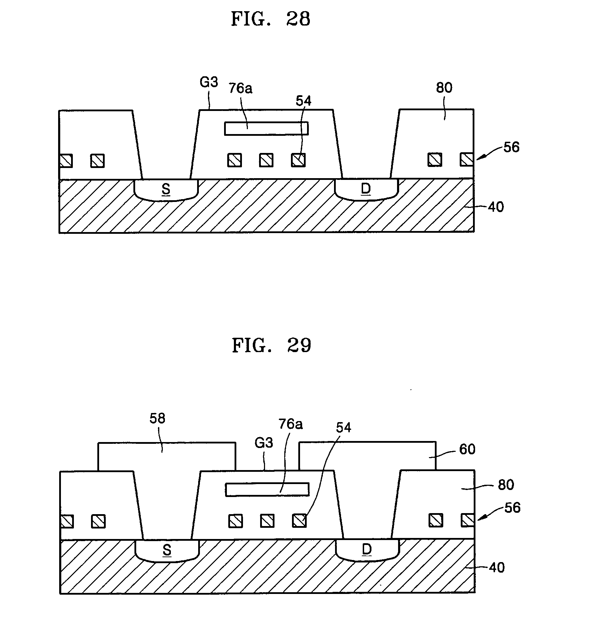

As described above, referring to FIG. 28, after forming the third gate G3, the source region S and the drain region D are formed in the exposed regions of the substrate 40. The source and drain regions S and D are formed by ionic injecting a conductive dopant which is an opposite type of conductive dopant that is injected to a predetermined region of the substrate 40 through the holes h3.

Referring to FIG. 29, a first metal layer 58 that contacts the source region S and a second metal layer 60 that contacts the drain region D are formed on the third gate G3. The first and the second metal layers 58 and 60 are separated from each other.

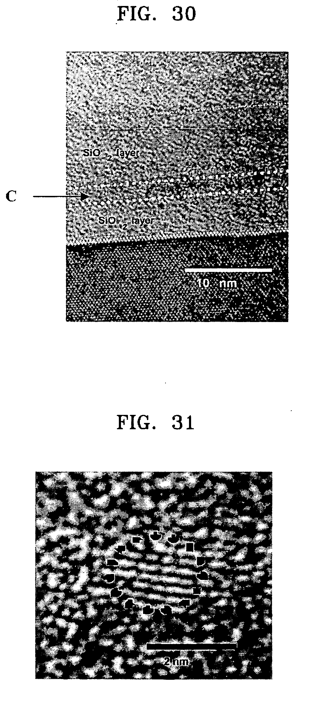

FIG. 30 is a SEM image of a cross-section of a gate of a memory device formed according to an embodiment of the present invention.

Referring to FIG. 30, a silicon nano dot layer C having a uniform size formed above a substrate (black portion) can be seen.

FIG. 31 is a SEM image of silicon nano dot crystals included in a gate of a memory device formed according to an embodiment of the present invention.

Referring to FIG. 31, it can be seen that size of crystals of the silicon nano dots are generally uniform.

As described above, in a method of manufacturing a memory device according to an embodiment of the present invention, a nano layer to be included in a gate is formed in advance only in a region where the gate will be formed. Therefore, when forming the gate is formed by etching the nano dots are not exposed, and the protrusion of nano dots from the gate or an uneven surface of the gate is prevented.

While the present invention has been particularly shown and described with reference to embodiments thereof, it should not be construed as being limited to the embodiments set forth herein. For example, one skilled in this art could apply the method of manufacturing a memory device according to the present invention to a different memory device that includes nano dots. Also, the nano dots can be formed in more than one layer. Furthermore, the nano dot layer in the first manufacturing method can be formed after forming the source and drain regions, and in the third manufacturing method, a silicon doping process can be performed after forming the seventh insulating film.

## Claims

1. A method of manufacturing a memory device, comprising:
forming a gate on a substrate, the gate including an insulating film and also a nano dot layer and a conductive film pattern which are sequentially stacked and separated by a predetermined distance from each other in the insulating film;
forming a source region and a drain region each in the substrate; and
forming first and second metal layers on the source region and the drain region, respectively.

2. The method of claim 1, wherein forming the gate comprises:
forming a gate stack on the substrate, the gate stack including the insulating film and also a material film for forming the nano dot layer and the conductive film pattern which are sequentially stacked and separated by a predetermined distance in the insulating film; and
transforming the material film to the nano dot layer, which includes at least one nano dot.

3. The method of claim 2, wherein transforming the material film includes annealing the gate stack until the material films for forming the nano dot layers become the nano dot layer.

4. The method of claim 3, wherein the gate is annealed at a temperature of 700-1100 °C for 30 seconds to1 hour.

5. The method of claim 2, 3 or 4, wherein the forming the gate stack comprises:
sequentially stacking a first insulating film, the material film for forming the nano dot layer, a second insulating film, a conductive film, and a third insulating film on the substrate;
forming a stack by patterning the first insulating film, the material film for forming the nano dot layer, the second insulating film, the conductive film, and the third insulating film; and
forming a spacer on a side surface of the stack.

6. The method of claim 2, 3, 4 or 5, wherein forming the source and drain regions is performed prior to the transforming the material film for forming the nano dot layer into the nano dot layers.

7. The method of claim 1, wherein the forming the gate comprises:
forming a first insulating film on the substrate;
forming a material film for forming nano dots on the first insulating film;
forming a nano dot material film pattern that confines a region for forming the gate by patterning the material film for forming nano dots;
transforming the nano dot material film pattern into the nano dot layer which includes at least one nano dot;
forming a second insulating film covering the nano dot layer on the first insulating film;
forming the conductive film pattern on a region of the second insulating film above the nano dot layer;
forming a third insulating film covering the conductive film pattern on the second insulating film; and
patterning the first through third insulating films so that the conductive film pattern and the nano dot layer are included in the resultant product.

8. The method of claim 7, wherein the first through third insulating films are formed of identical materials.

9. The method of claim 7 or 8, wherein the material film for forming the nano dots is transformed into the nano dot layer by annealing.

10. The method of claim 9, wherein the annealing is performed at a temperature of 700-1100 °C for 30 seconds to 1 hour.

11. The method of claim any of claims 2 to 10, wherein the or each material film for forming the nano dot is one of a SiO₂₋ₓ film and a Si₃N₄₋ₓ film (0<x<1).

12. The method of claim 1, wherein the forming gate comprises:
forming a first insulating film on the substrate;
injecting seeds for forming nano dots in the first insulating film;
forming a first insulating film pattern that defines a region for forming a gate by patterning the first insulating film in which the seeds are injected;
forming a nano dot layer that includes at least one nano dot in the first insulating film pattern;
forming a second insulating film covering the first insulting film pattern including the nano dot layer on the substrate;
forming a conductive film pattern on a portion of the second insulating film directly above the nano dot layer;
forming a third insulating film covering the conductive film pattern on the second insulating film; and
patterning the first through third insulating films so that the conductive film pattern and the nano dot layer are included in the resultant product.

13. The method of claim 12, wherein the first through third insulating films are formed with a silicon oxide film.

14. The method of claim 12 or 13, wherein the seeds are silicon seeds.

15. The method of claim 12, 13 or 14, wherein the patterning the first insulating film is performed prior to the injecting the seeds for forming nano dots into the first insulating film.

16. The method of any of claims 12 to 15, wherein the nano dot layer is formed by annealling the first insulating film pattern.

17. The method of claim 16, wherein the annealing is performed at a temperature of 700-1100 °C for 30 seconds to 1 hour.
